# EUROPEAN PATENT APPLICATION

(11) **EP 4 603 901 A1**
(43) Date of publication of application: **20.08.2025**
(21) Application number: 24214574.6
(22) Date of filing: 21.11.2024
(51) Int. Cl.: G02F 1/1335, G02F 1/1337, G02F 1/1343

(54) **PIXEL ARRAY SUBSTRATE**

(30) Priority: 19.02.2024 US 202463555105 P; 11.04.2024 TW 113113609
(71) Applicant: Hannstar Display Corporation, Taipei City 114762 (TW)
(72) Inventor: CHIAO, Yu-Chi, 114762 Taipei City (TW); CHEN, I-Tung, 114762 Taipei City (TW); WU, Chiung-Chang, 114762 Taipei City (TW); WANG, Chun Chieh, 114762 Taipei City (TW); TSAI, Ming Han, 114762 Taipei City (TW)
(74) Representative: Becker, Eberhard

(57) **Abstract**

A pixel array substrate (100, 100A) including a substrate (101), an insulation layer (120, 130), and multiple pixel structures (PX) is provided. The insulation layer (120, 130) is disposed on the substrate (101). The pixel structures (PX) are disposed on the substrate (101), and each includes an active device (TFT) and a reflective layer (RFL). The active device (TFT) is disposed between the substrate (101) and the insulation layer (120, 130). The reflective layer (RFL) is disposed on the insulation layer (120, 130), and includes a silver-based reflective layer (151) and a protective layer (152). The protective layer (152) covers the silver-based reflective layer (151). A thickness (t) of the protective layer (152) is greater than or equal to 30 angstroms and less than or equal to 80 angstroms. Another pixel array substrate (100, 100A) having a buffer layer (153) is also provided.

## Description

### BACKGROUND

### Technical Field

The disclosure relates to a pixel array substrate, and more particularly, to a pixel array substrate provided with a reflective layer.

### Description of Related Art

Natural light or ambient light are mainly used for a reflective display panel as a light source for display, making the reflective display panel have good energy-saving characteristics. Therefore, it is often used outdoors or in areas with sufficient light, such as outdoor billboards, electronic tags, sports watches, etc. Considering high reflectivity and low resistivity, silver is the first choice among all metallic elements as a reflective layer.

Since silver has poor chemical resistance, heat resistance, and weather resistance, and has high electrochemical mobility, silver has many problems and problems and limitations in manufacturing a reflective electrode of a reflective or transflective display panel. For example, etching and heating steps are often involved in other processes after a silver process, resulting in changes in optical properties of a silver reflective layer (such as a decrease in reflectivity or color shift of the reflective light) and deterioration in reliability (such as a phenomenon of the silver reflective layer being peeled off from an underlying film layer).

### SUMMARY

The disclosure provides a pixel array substrate, which has a higher process yield and better optical performance.

A pixel array substrate in the disclosure includes a substrate, an insulation layer, and multiple pixel structures. The insulation layer is disposed on the substrate. The pixel structures are disposed on the substrate, and each includes an active device and a reflective layer. The active device is disposed between the substrate and the insulation layer. The reflective layer is disposed on the insulation layer, and includes a silver-based reflective layer and a protective layer. The silver-based reflective layer has a reflective surface. The protective layer covers the silver-based reflective layer. A thickness of the protective layer along a normal direction of the reflective surface is greater than or equal to 30 angstroms and less than or equal to 80 angstroms.

A pixel array substrate in the disclosure includes a substrate, an insulation layer, and multiple pixel structures. The insulation layer is disposed on the substrate. The pixel structures are disposed on the substrate, and each includes an active device and a reflective layer. The active device is disposed between the substrate and the insulation layer. The reflective layer is disposed on the insulation layer, and includes a silver-based reflective layer and a buffer layer. The silver-based reflective layer has a reflective surface. The buffer layer is disposed between the insulation layer and the silver-based reflective layer. A material of the buffer layer includes a conductive material. The insulation layer has an opening and a side wall surface defining the opening. The silver-based reflective layer and the buffer layer extend to cover the side wall surface of the insulation layer. A first thickness of a side wall portion of the buffer layer covering the side wall surface along a normal direction of the side wall surface is greater than or equal to 30 angstroms and less than or equal to 80 angstroms.

Based on the above, in the pixel array substrate according to an embodiment of the disclosure, in order to increase the chemical resistance and the weather resistance of the silver-based reflective layer during the manufacturing process, it is covered with the protective layer, and the thickness of the protective layer ranges from 30 angstroms to 80 angstroms. In addition to better uniformity of the film thickness, the protective layer may also prevent the reflectivity of the reflective layer from decreasing or causing color shift due to the configuration of the protective layer. In the pixel array substrate according to another embodiment of the disclosure, the buffer layer is provided between the silver-based reflective layer and the insulation layer, and the thickness of the side wall portion of the buffer layer in the opening of the insulation layer ranges from 30 angstroms to 80 angstroms. In addition to increasing the adhesion between the silver-based reflective layer and the insulation layer, it may also prevent the issue of unclean etching of the reflective layer during the patterning process since the buffer layer is too thick.

### BRIEF DESCRIPTION OF THE DRAWINGS

FIG. 1 is a schematic cross-sectional view of a display panel according to an embodiment of the disclosure.
FIG. 2 is a schematic enlarged view of a partial area of the display panel in FIG. 1.
FIG. 3 is a schematic enlarged view of a pixel array substrate in FIG. 2.
FIG. 4 is a schematic cross-sectional view of a display panel according to another embodiment of the disclosure.
FIG. 5 is a schematic enlarged view of a pixel array substrate in FIG. 4.

### DETAILED DESCRIPTION OF DISCLOSED EMBODIMENTS

Reference will now be made in detail to the exemplary embodiments of the disclosure, and examples of the exemplary embodiments are illustrated in the accompanying drawings. Whenever possible, the same reference numerals are used in the drawings and descriptions to indicate the same or similar parts.

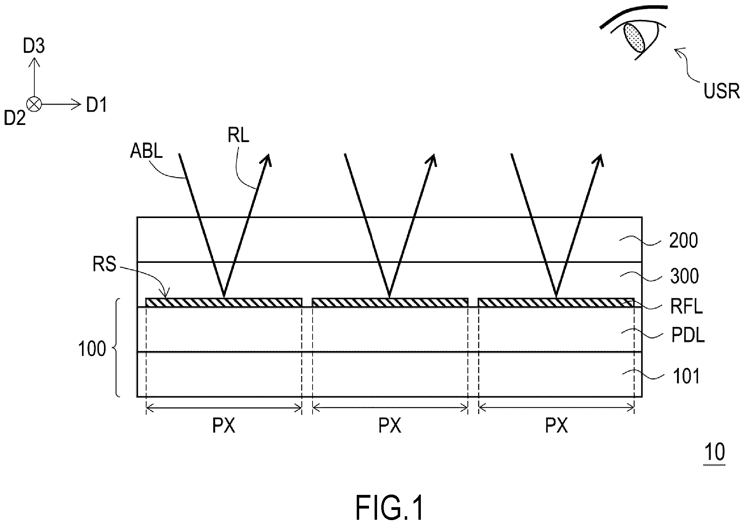

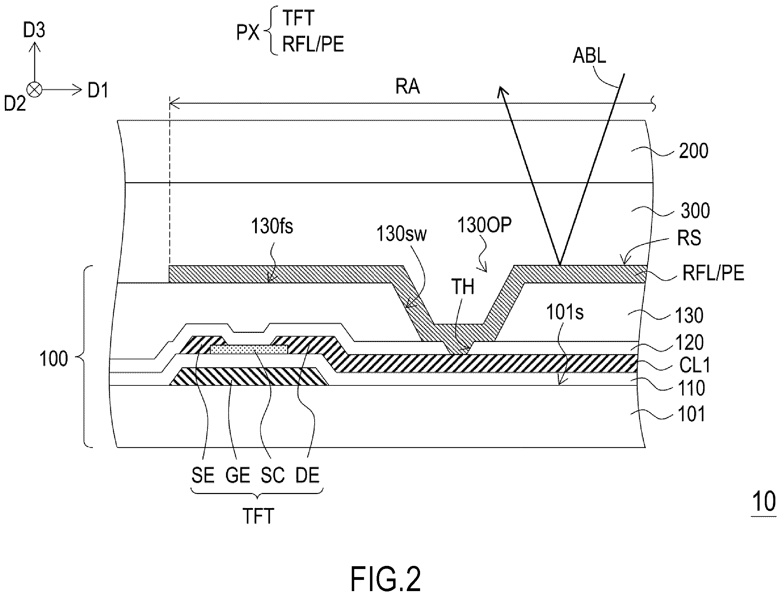

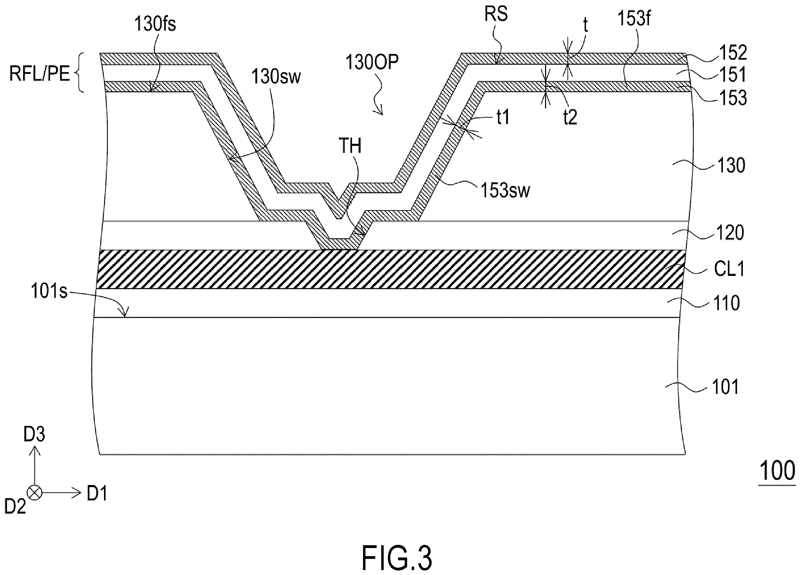

FIG. 1 is a schematic cross-sectional view of a display panel according to an embodiment of the disclosure. FIG. 2 is a schematic enlarged view of a partial area of the display panel in FIG. 1. FIG. 3 is a schematic enlarged view of a pixel array substrate in FIG. 2.

Referring to FIGs. 1 and 2, a display panel 10 may include a pixel array substrate 100, a color filter substrate 200, and a liquid crystal layer 300. The pixel array substrate 100 and the color filter substrate 200 are disposed to overlap each other, and the liquid crystal layer 300 is disposed between the pixel array substrate 100 and the color filter substrate 200. That is, the display panel 10 is, for example, a liquid crystal display panel, but the disclosure is not limited thereto. In other embodiments, the liquid crystal layer 300 may be replaced with other types of display medium layers.

It should be noted first that an overlapping relationship between the pixel array substrate 100 and the color filter substrate 200 means, for example, that the two overlap each other along a direction D3. Unless otherwise mentioned below, the overlapping relationship between the two components is defined in the same way, and an overlapping direction thereof will not be repeated again.

The pixel array substrate 100 includes a substrate 101 and multiple pixel structures PX disposed on the substrate 101. A material of the substrate 101 may include glass, quartz, high molecular polymers (e.g., polyimide, polycarbonate, polymethyl methacrylate, or other suitable flexible plate materials), or other suitable plate materials.

In this embodiment, the pixel structures PX are arranged in an array on the substrate 101. For example, the pixel structures PX may be arranged into multiple pixel columns and multiple pixel rows along a direction D1 and a direction D2 perpendicular to each other. The pixel array substrate 100 may be provided with a pixel driving layer PDL. Each of the pixel structures PX may include an active device TFT disposed in the pixel driving layer PDL and a reflective layer RFL disposed on the pixel driving layer PDL. For example, the pixel driving layer PDL may further be provided with multiple scan lines (not shown) and multiple data lines (not shown). The active device TFT may be electrically connected to a scan line and a data line, but the disclosure is not limited thereto. In particular, the reflective layer RFL in this embodiment may be conductive and serve as a pixel electrode PE of the pixel structure PX at the same time, but the disclosure is not limited thereto. An area of the reflective layer RFL may be defined as a reflective area RA of the display panel 10. In this embodiment, the display panel 10 may be a reflective display panel, but the disclosure is not limited thereto. In other embodiments, the display panel 10 may further be a transflective display panel. For example, each of the pixel structures PX of the display panel 10 may further include a transmission area (not shown), the reflective layer RFL is disposed in the reflective area RA but not in the transmission area, and light from a backlight module (not shown) may pass through the transmission area.

On the other hand, the color filter substrate 200 may be provided with a color filter layer (not shown) and a common electrode layer (not shown), but the disclosure is not limited thereto. An electric field generated between the common electrode layer and the reflective layer RFL (i.e., the pixel electrode PE) is adapted to drive multiple liquid crystal molecules (not shown) of the liquid crystal layer 300 to rotate to form an arrangement state corresponding to a direction and intensity of the electric field. It is noted that ambient light or light of a front light module in each of FIGs. 1 and 2 is labelled as "ABL". By changing the arrangement state of the liquid crystal molecules, a polarization state of the ambient light ABL or the light ABL of the front light module passing through the liquid crystal layer 300 is changed to form a light intensity corresponding to the arrangement state.

In this embodiment, the ambient light ABL or the light ABL of the front light module is used as an illumination source for the display panel 10 during display, and the ambient light ABL or the light ABL of the front light module passing through the liquid crystal layer 300 is reflected by the reflective layer RFL to pass through the liquid crystal layer 300 again to form reflective light RL with a specific light intensity. By controlling the intensity of the electric field between each of the pixel electrodes PE of the pixel structures PX and the common electrode layer, the multiple reflective light RL reflected by the reflective layers RFL of the pixel structures PX to be transmitted to a user USR may have different light intensities to achieve an effect of displaying images.

Furthermore, a step of forming the active device TFT includes, for example, sequentially forming a gate GE, a gate insulation layer 110, a semiconductor pattern SC, a source SE, and a drain DE on the substrate 101. The semiconductor pattern SC is disposed to overlap the gate GE. The source SE and the drain DE overlap the semiconductor pattern SC, and are in electrical contact with two different areas of the semiconductor pattern SC. In this embodiment, the gate GE of the active device TFT may be selectively disposed below the semiconductor pattern SC to form a bottom-gate thin film transistor (bottom-gate TFT), but the disclosure is not limited thereto. In other embodiments, the gate of the active device may be selectively disposed above the semiconductor pattern to form a top-gate thin film transistor (top-gate TFT).

Furthermore, the active device TFT may be covered with an insulation layer 120 and an insulation layer 130 sequentially. In this embodiment, the insulation layer 120 is, for example, a passivation layer, and the insulation layer 130 is, for example, a planarization layer. In some embodiments, the pixel array substrate 100 may not include the insulation layer 120. In this embodiment, the insulation layer 120 has a contact hole TH, and the contact hole TH passes through the insulation layer 120. The insulation layer 130 has an opening 130OP overlapping the contact hole TH, a side wall surface 130sw defining the opening 130OP, and a surface 130fs connected to the side wall surface 130sw, and the opening 130OP passes through the insulation layer 130. The surface 130fs is a surface of the insulation layer 130 facing away from the substrate 101, and an extension direction of the side wall surface 130sw intersects with a substrate surface 101s.

The reflective layer RFL of the pixel structure PX is disposed on the surface 130fs of the insulation layer 130, and is electrically connected to the drain DE of the active device TFT through the opening 130OP of the insulation layer 130 and the contact hole TH of the insulation layer 120. For example, in this embodiment, the pixel driving layer PDL may further be provided with a conductive layer CL1 extending from the drain DE of the active device TFT, and the opening 130OP and the contact hole TH expose a portion of a surface of the conductive layer CL1. The reflective layer RFL disposed on the surface 130fs further extends to cover the side wall surface 130sw of the insulation layer 130 and the contact hole TH of the insulation layer 120 to be electrically connected to the conductive layer CL1.

It should be noted that the gate GE, the source SE, the drain DE, the semiconductor pattern SC, the gate insulation layer 110, the passivation layer (i.e. the insulation layer 120), and the planarization layer (i.e. the insulation layer 130) may be respectively implemented by any gate, any source, any drain, any semiconductor pattern, any gate insulation layer, any passivation layer, and any planarization layer for the reflective display panel that are well known to those skilled in the art, and the gate GE, the source SE, the drain DE, the semiconductor pattern SC, the gate insulation layer 110, the passivation layer, and the planarization layer may be respectively formed by any method well known to those skilled in the art. Therefore, the same details will not be repeated in the following.

Referring to FIGs. 2 and 3, the reflective layer RFL is a stacked structure of multiple film layers. In this embodiment, the reflective layer RFL includes, for example, a silver-based reflective layer 151, a protective layer 152, and a buffer layer 153. However, the disclosure is not limited thereto. In other embodiments, in addition to the silver-based reflective layer 151, the reflective layer may also be provided with only one of the protective layer 152 and the buffer layer 153. In this embodiment, a material of the silver-based reflective layer 151 is, for example, a silver element or a metal alloy material containing the silver element.

The silver-based reflective layer 151 has a reflective surface RS, and the protective layer 152 covers the reflective surface RS of the silver-based reflective layer 151. A material of the protective layer 152 includes a light-transmitting conductive material. In this embodiment, the protective layer 152 may include indium-containing oxide, such as indium tin oxide (ITO) or indium zinc oxide (IZO).

In particular, the configuration of the protective layer 152 may prevent the silver-based reflective layer 151 from being exposed to the air for a long time during a manufacturing process, causing material deterioration and affecting optical properties (such as color change and/or a decrease in reflectivity of the reflective layer RFL). When a thickness of the protective layer 152 is too thick, the reflectivity of the reflective layer RFL decreases, and the image becomes yellowish. When the thickness of the protective layer 152 is too thin, the protective layer 152 is easily broken. Therefore, in this embodiment, a thickness t of the protective layer 152 along a normal direction of the reflective surface RS is greater than or equal to 30 angstroms and less than or equal to 80 angstroms. Preferably, the thickness t may be greater than or equal to 50 angstroms and less than or equal to 60 angstroms. Considering uniformity of a film thickness of the protective layer 152 during fabrication, when the thickness t of the protective layer 152 is 30 angstroms, the film thickness thereof may still be uniform to prevent the protective layer 152 from being broken, thereby ensuring chemical resistance and weather resistance of the reflective layer RFL during the manufacturing process. In addition, it may also reduce an impact of the protective layer 152 on the optical properties of the silver-based reflective layer 151 (that is, reducing the decrease in the reflectivity of the reflective layer RFL). On the other hand, even if the thickness t of the protective layer 152 is 80 angstroms, it will also not cause an issue of underetching of the reflective layer RFL during a patterning process.

In this embodiment, the buffer layer 153 is disposed between the insulation layer 130 and the silver-based reflective layer 151. A material of the buffer layer 153 may be similar to the material of the protective layer 152, and may include, for example, indium-containing oxide. However, the disclosure is not limited thereto. In this embodiment, the material of the buffer layer 153 may include a light-transmitting or opaque conductive material. For example, the material of the buffer layer 153 includes metal oxide (such as ITO, IZO, MoTaOₓ or MoOₓ), Mo, MoTa, AlNd, Ti, or Cr. It is particularly noted that the buffer layer 153 covers the surface 130fs of the insulation layer 130 and further extends to cover the side wall surface 130sw of the insulation layer 130 and is electrically connected to the conductive layer CL1. More specifically, the silver-based reflective layer 151 is connected to the insulation layer 130 through the buffer layer 153.

The configuration of the buffer layer 153 may increase adhesion between the silver-based reflective layer 151 and the insulation layer 130 to prevent the silver-based reflective layer 151 from being peeled off from the insulation layer 130. In this embodiment, the buffer layer 153 has a side wall portion 153sw covering the side wall surface 130sw and a horizontal portion 153f covering the surface 130fs. The side wall portion 153sw of the buffer layer 153 extends along the side wall surface 130sw of the insulation layer 130, and the horizontal portion 153f of the buffer layer 153 extends along the surface 130fs of the insulation layer 130. Due to a shadow effect, a film thickness of the side wall portion 153sw will be thinner than a film thickness of the horizontal portion 153f.

When a thickness of the buffer layer 153 is too thick, the reflective layer RFL is not etched cleanly during the patterning process. When the thickness of the buffer layer 153 is too thin, the side wall portion 153sw of the buffer layer 153 is prone to be too thin, resulting in discontinuity in film deposition, causing the silver-based reflective layer 151 to be peeled off. Therefore, in this embodiment, a first thickness t1 of the side wall portion 153sw of the buffer layer 153 along a normal direction of the side wall surface 130sw is greater than or equal to 30 angstroms and less than or equal to 80 angstroms. A second thickness t2 of the horizontal portion 153f of the buffer layer 153 along a normal direction of the surface 130fs is greater than or equal to 40 angstroms and less than or equal to 100 angstroms. Preferably, the first thickness t1 may be greater than or equal to 50 angstroms and less than or equal to 60 angstroms, and the second thickness t2 may be greater than or equal to 70 angstroms and less than or equal to 80 angstroms.

In particular, when the first thickness t1 of the side wall portion 153sw of the buffer layer 153 is 30 angstroms, the film thickness thereof is uniform to prevent the side wall portion 153sw of the buffer layer 153 from being broken, thereby ensuring an adhesion relationship between the silver-based reflective layer 151 and the insulation layer 130. On the other hand, even if the first thickness t1 of the side wall portion 153sw of the buffer layer 153 is 80 angstroms, or the second thickness t2 of the horizontal portion 153f of the buffer layer 153 is 100 angstroms, it will also not cause the issue of underetching of the reflective layer RFL during the patterning process.

Some other embodiments are provided below to describe the invention in detail, where the same reference numerals denote the same or like components, and descriptions of the same technical contents are omitted. The aforementioned embodiment may be referred for descriptions of the omitted parts, and detailed descriptions thereof are not repeated in the following embodiment.

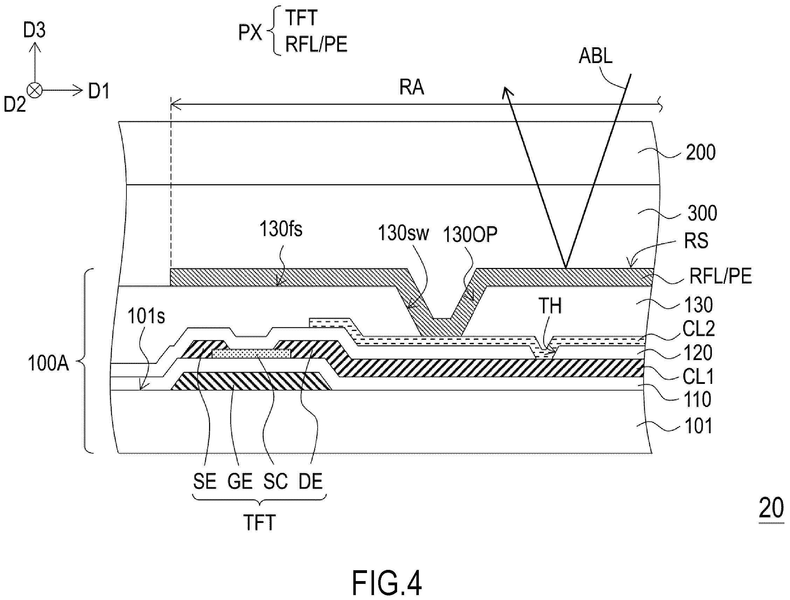

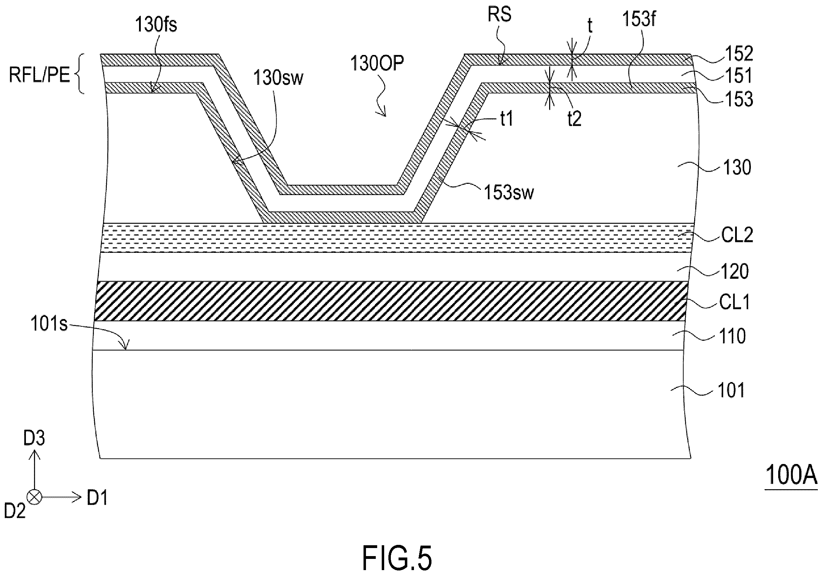

FIG. 4 is a schematic cross-sectional view of a display panel according to another embodiment of the disclosure. FIG. 5 is a schematic enlarged view of a pixel array substrate in FIG. 4. Referring to FIGs. 4 and 5, a difference between a display panel 20 in this embodiment and the display panel 10 in FIG. 2 is that an electrical connection method between the reflective layer and the drain of the active device is different.

For example, in this embodiment, a pixel array substrate 100A may further selectively include another conductive layer CL2. The conductive layer CL2 is disposed between the insulation layer 120 and the insulation layer 130, and is electrically connected to the conductive layer CL1 extending from the drain DE of the active device TFT through the contact hole TH of the insulation layer 120. The opening 130OP of the insulation layer 130 exposes a portion of a surface of the conductive layer CL2, and the reflective layer RFL extends to cover the portion of the surface of the conductive layer CL2 to be electrically connected to the conductive layer CL2.

More specifically, in this embodiment, the reflective layer RFL (i.e., the pixel electrode PE) is electrically connected to the drain DE of the active device TFT through a bridge structure formed by the conductive layer CL2 and the conductive layer CL 1. A material of the conductive layer CL2 includes, for example, light-transmitting conductive materials, such as indium tin oxide (ITO) or indium zinc oxide (IZO), but the disclosure is not limited thereto. In other embodiments, the material of the conductive layer CL2 may include metal or alloy.

Since the components not mentioned in this embodiment are similar to those of the display panel 10 in FIG. 2 , and ranges of the thickness t of the protective layer 152 and the first thickness t1 and the second thickness t2 of the buffer layer 153 are the same as those in the previous embodiment, relevant paragraphs of the foregoing embodiments may be referred for detailed description. Therefore, the same details will not be repeated in the following.

Based on the above, in the pixel array substrate according to an embodiment of the disclosure, in order to increase the chemical resistance and the weather resistance of the silver-based reflective layer during the manufacturing process, it is covered with the protective layer, and the thickness of the protective layer ranges from 30 angstroms to 80 angstroms. In addition to better uniformity of the film thickness, the thickness range of the protective layer may also prevent the reflectivity of the reflective layer from decreasing or causing color shift due to the configuration of the protective layer. In the pixel array substrate according to another embodiment of the disclosure, the buffer layer is provided between the silver-based reflective layer and the insulation layer. The thickness of the horizontal portion of the buffer layer ranges from 40 angstroms to 100 angstroms, and the thickness of the side wall portion of the buffer layer in the opening of the insulation layer ranges from 30 angstroms to 80 angstroms. In addition to increasing the adhesion between the silver-based reflective layer and the insulation layer, it may also prevent the issue of underetching of the reflective layer during the patterning process.

## Claims

1. A pixel array substrate (100, 100A), comprising:
a substrate (101);
an insulation layer (120, 130) disposed on the substrate (101); and
a plurality of pixel structures (PX) disposed on the substrate (101), and each comprising:
an active device (TFT) disposed between the substrate (101) and the insulation layer (120, 130); and
a reflective layer (RFL) disposed on the insulation layer (120, 130), and comprising:
a silver-based reflective layer (151) having a reflective surface (RS); and
a protective layer (152) covering the silver-based reflective layer (151),
wherein a thickness (t) of the protective layer (152) along a normal direction of the reflective surface (RS) is greater than or equal to 30 angstroms and less than or equal to 80 angstroms.

2. The pixel array substrate (100, 100A) according to claim 1, wherein a material of the protective layer (152) comprises a light-transmitting conductive material.

3. The pixel array substrate (100, 100A) according to claim 1, wherein the thickness (t) of the protective layer (152) is greater than or equal to 50 angstroms and less than or equal to 60 angstroms.

4. The pixel array substrate (100, 100A) according to claim 1, wherein the reflective layer (RFL) further comprises a buffer layer (153) disposed between the insulation layer (120, 130) and the silver-based reflective layer (151), and a material of the buffer layer (153) comprises a conductive material.

5. The pixel array substrate (100, 100A) according to claim 4, wherein the insulation layer (130) has an opening (130OP) and a side wall surface (130sw) defining the opening (130OP), the silver-based reflective layer (151) and the buffer layer (153) extend to cover the side wall surface (130sw) of the insulation layer (130), and a first thickness (t1) of a side wall portion (153sw) of the buffer layer (153) covering the side wall surface (130sw) along a normal direction of the side wall surface (130sw) is greater than or equal to 30 angstroms and less than or equal to 80 angstroms.

6. The pixel array substrate (100, 100A) according to claim 5, wherein the insulation layer (130) further has a surface (130fs) connected to the side wall surface (130sw), the surface (130fs) faces away from the substrate (101), and a second thickness (t2) of a horizontal portion (153f) of the buffer layer (153) covering the surface (130fs) of the insulation layer (130) along a normal direction of the surface (130fs) is greater than or equal to 40 angstroms and less than or equal to 100 angstroms.

7. The pixel array substrate (100, 100A) according to claim 6, wherein the first thickness (t1) is greater than or equal to 50 angstroms and less than or equal to 60 angstroms, and the second thickness (t2) is greater than or equal to 70 angstroms and less than or equal to 80 angstroms.

8. A pixel array substrate (100, 100A), comprising:
a substrate (101);
an insulation layer (130) disposed on the substrate (101); and
a plurality of pixel structures (PX) disposed on the substrate (101), and each comprising:
an active device (TFT) disposed between the substrate (101) and the insulation layer (130); and
a reflective layer (RFL) disposed on the insulation layer (130), and comprising:
a silver-based reflective layer (151) having a reflective surface (RS); and
a buffer layer (153) disposed between the insulation layer (130) and the silver-based reflective layer (151), wherein a material of the buffer layer (153) comprises a conductive material,
wherein the insulation layer (130) has an opening (130OP) and a side wall surface (130sw) defining the opening (130OP), the silver-based reflective layer (151) and the buffer layer (153) extend to cover the side wall surface (130sw) of the insulation layer (130), and a first thickness (t1) of a side wall portion (153sw) of the buffer layer (153) covering the side wall surface (130sw) along a normal direction of the side wall surface (130sw) is greater than or equal to 30 angstroms and less than or equal to 80 angstroms.

9. The pixel array substrate (100, 100A) according to claim 8, wherein the reflective layer (RFL) further comprises:
a protective layer (152) covering the silver-based reflective layer (151), wherein a thickness (t) of the protective layer (152) along a normal direction of the reflective surface (RS) is greater than or equal to 30 angstroms and less than or equal to 80 angstroms.

10. The pixel array substrate (100, 100A) according to claim 8, wherein the insulation layer (130) further has a surface (130fs) connected to the side wall surface (130sw), the surface (130fs) faces away from the substrate (101), and a second thickness (t2) of a horizontal portion (153f) of the buffer layer (153) covering the surface (130fs) of the insulation layer (130) along a normal direction of the surface (130fs) is greater than or equal to 40 angstroms and less than or equal to 100 angstroms.
